## Europäisches Patentamt

## European Patent Office

## Office européen des brevets

(19)

(11) Veröffentlichungsnummer: **0 144 078**
**A2**

(12) # EUROPÄISCHE PATENTANMELDUNG

(21) Anmeldenummer: 84114469.4

(22) Anmeldetag: 29.11.84

(51) Int. Cl.⁴: **G 01 R 31/28**

(30) Priorität: 01.12.83 US 556812

(43) Veröffentlichungstag der Anmeldung:
12.06.85 Patentblatt 85/24

(84) Benannte Vertragsstaaten:
AT CH DE FR GB IT LI NL

(71) Anmelder: **Siemens Aktiengesellschaft**
**Berlin und München Wittelsbacherplatz 2**
**D-8000 München 2(DE)**

(72) Erfinder: **Tischler, Erwin**
**500 Adams Lane Apt. 2B**
**North Brunswick, NJ 08902(US)**

(54) Verfahren und Anordnung zum Prüfen einer Schaltung nach der Abfragepfad-Technik.

(57) Verfahren zum Prüfen einer komplexen digitalen Schaltung (10), die jeweils mehrere primäre Eingänge (16), primäre Ausgänge (18) und Flipflops (12, 14) enthält, wobei wenigstens einige (12) der letzteren wahlweise zu einem Abfragepfad-Schieberegister verbindbar sind, das einen Eingang und einen Ausgang aufweist. Eine Erhöhung der Fehlererkennungsrate wird dadurch erreicht, daß ein erstes digitales Testmuster an die primären Eingänge (16) gelegt wird und ein zweites digitales Testmuster Bit für Bit in das Abfragepfad-Schieberegister eingeschoben wird. Die Bits, die an den primären Ausgängen (18) erscheinen, werden mit ersten digitalen Zahlen verglichen, die eine einwandfreie Funktion der Schaltung (10) anzeigen, wobei jeweils nach dem Einschieben eines Bits des zweiten digitalen Testmusters ein solcher Vergleich durchgeführt wird. Wenn die an den primären Ausgängen (18) erscheinenden Bits nicht mit denen der zum Vergleich herangezogenen digitalen Zahlen übereinstimmen, wird ein Signal erzeugt, das eine Fehlfunktion der Schaltung (10) anzeigt.

./...

FIG. 2

Siemens Aktiengesellschaft    Unser Zeichen
Berlin und München            VPA 83 P 7445 E

_1_

Verfahren und Anordnung zum Prüfen einer Schaltung nach der Abfragepfad-Technik

Die vorliegende Erfindung bezieht sich auf ein Verfahren zum Prüfen einer komplexen digitalen Schaltung nach dem Oberbegriff des Anspruchs 1 sowie auf eine Anordnung zur Durchführung desselben.

Bei der Entwicklung von digitalen Schaltungen, insbesondere Computer- und Datenverarbeitungsschaltungen, hat sich die Schaltungsdichte exponentiell erhöht. Dies ist den allgemeinen Fortschritten in der Halbleitertechnologie, in der Computerentwicklung und in den die Miniaturisierung der Komponenten betreffenden Verfahren zuzuschreiben.

Da sich die Erhöhung der Schaltungsdichte auf einem Chip in verringerten Kosten pro Gatter widerspiegelt, kann eine Kostenverringerung durch eine Erhöhung des Integrationsgrades der Schaltung erreicht werden, d.h. durch eine Erhöhung der Anzahl der Gatterfunktionen pro Chip. Obwohl sich nun diese Anzahl exponentiell vergrößert hat, hat sich die Anzahl der Anschlußstifte pro Chip nur annähernd linear erhöht. Da die Anzahl der Anschlußstifte wegen der praktischen mechanischen Begrenzungen nicht in einfacher Weise vergrößert werden kann, hat sich die Anzahl der Gatter pro Anschlußstift ebenfalls exponentiell erhöht. Als Folge davon wird es immer schwieriger, die Zugänglichkeit zu internen Schaltungspunkten von Chips mit integrierten Schaltungen zu gewährleisten.

St 1 Sti/22.11.1984

Es ist bekannt, daß der Prüfungsaufwand entsprechend der oben erwähnten wachsenden Komplexität und Dichte digitaler Schaltungen ebenfalls exponentiell angestiegen ist. Das Verhältnis von Prüfkosten zu den gesamten Produktionskosten hat sich im Laufe der Zeit ebenfalls vergrößert. Die Prüfbarkeit von digitalen Schaltungen erhält nun eine besondere Beachtung wegen der wesentlichen ökonomischen Bedeutung des Prüfens solcher Schaltungen.

Untersuchungen haben gezeigt, daß sich die Kosten einer Fehlerlokalisierung in unterschiedlichen Stufen des Prüfens um eine Größenordnung erhöhen. Nach dem Bericht "Testability" von J. Turino, ATE Seminar, Pasadena, CA., Januar 1981, betragen die Kosten für das Auffinden eines einzigen fehlerhaften Bauelementes:

$     0.05 bei Chips aufnehmenden Prüfstationen (Stichprobenprüfung)

$     0.50 bei Chips aufnehmenden Prüfstationen (100%ige Prüfung)

$     5.00 auf der Ebene der gedruckten Schaltungsplatte,

$    50.00 auf der Systemprüfungsebene und

$   500.00 am Einsatzort.

Somit sind die Kosten um so niedriger, je eher ein Fehler im Herstellungsprozeß gefunden werden kann. Daher wurden in der Forschung wesentliche Anstrengungen gemacht, um

a) die Fehlerlokalisierung in das früheste Prüfstadium zu verlegen, was dadurch geschieht, daß sie ganz zu Anfang während der Phase des Schaltungsentwurfs durchgeführt wird,

b) das Prüfungs- und Fehlerlokalisierungsverfahren zu vereinfachen, um die Kosten für jeden einzelnen Schritt zu reduzieren.

Da die Methoden der Testgeneration und Simulation, die bisher benutzt wurden, in vielen Fällen die Grenzen ihrer Leistungsfähigkeit erreicht haben, werden brauchbare alternative Prüfmethoden gesucht. Eine solche Methode besteht darin, eine Schaltungsarchitektur und -struktur so zu entwerfen, daß sie während der Entwurfsphase in einfacher Weise geprüft werden kann. Diese Methode wird auch als "Design for Testability" bezeichnet.

Wenn man diese Methode anwendet, wird eine bedeutsame Kostenreduzierung dann erreicht, wenn man Schaltungs-"hardware" hinzufügt, die eine Schaltung, welche schwierig zu testen ist, in eine einfach zu testende Schaltung transformiert. Das vereinfacht den Schritt der Testgeneration (Ersatz der Testgeneration von Hand durch automatische Testmuster-Generationssysteme), reduziert Simulationskosten und reduziert die Anzahl von Testmustern und deswegen auch die Kosten für die automatischen Prüfgeräte.

Die am meisten verwendeten "Design for Testability"-Maßnahmen beruhen auf der Erkenntnis, daß, wenn der Schaltzustand aller Flipflops jeweils auf einen beliebigen spezifischen Wert eingestellt werden kann und wenn sie bei jeder direkten Operation beobachtet werden können, die Testgeneration und Fehlersimulation auf das reduzierbar ist, was für eine logische Schaltung erforderlich ist. Ein Steuersignal kann die Flipflops aus ihrem normalen Betriebsmodus in einen Modus umschalten, in dem sie steuerbar und beobachtbar sind. Strukturen, die eine solche Arbeitsweise erlauben, sind als sog. Abtaststrukturen (scan structures) bekannt.

So zeigt beispielsweise das US-Patent 3 761 695 eine Prüftechnik für eine digitale Schaltung, bei der interne Speicherelemente (soweit es sich nicht um Speicheranordnungen handelt) so miteinander verbunden werden, daß sie
auch als Schieberegister betrieben werden können und auf
diese Weise einen sog. Abfragepfad (scan path) bilden.

Zu einem solchen Abfragepfad gehören zwei Betriebsweisen:
eine erste, die dem normalen Betriebsmodus entspricht,
und eine zweite, die einem Testmodus entspricht und in
der die Flipflops der Schaltung miteinander zu einem
langen Schieberegister verbunden sind, das als Abfragepfad bezeichnet wird. Befindet sich die Schaltung im
Testmodus, so ist es möglich, ein beliebiges Testmuster
in die Flipflops einzugeben (diese zu laden). Durch ein
Umschalten der Schaltung in ihren normalen Betriebsmodus für die Dauer einer Taktperiode reagiert der übrige Teil der Schaltung auf die Inhalte der Flipflops und
auf primäre Eingangssignale und speichert Ergebnisse in
den zum Abfragepfad gehörenden Flipflops ab. Wird die
Schaltung dann in den Testmodus zurückgeschaltet, ist es
möglich, die Inhalte der Abfragepfad-Flipflops hinauszuschieben (diese zu entladen) und diese Inhalte und die
primären Ausgangssignale mit geeigneten Sollwerten zu
vergleichen. Das n-te Flipflop in einem Schieberegister
der Länge k kann kontrolliert werden nach n Taktimpulsen ($k \geq n$).

Wenn alle Flipflops in einen Abfragepfad einbezogen
sind, wird dieser als ein vollständiger oder voller
Abfragepfad bezeichnet. Sind jedoch einige Flipflops
nicht in den Abfragepfad einbezogen, so bezeichnet man
diesen als einen unvollständigen oder partiellen Abfragepfad. Bei einem vollständigen Abfragepfad wird angenommen, daß alle Flipflops einer Schaltung, ausgenommen die Speicheranordnungen (ROMs, RAMs usw.) in den Abfragepfad einbezogen sind. Der übrige Teil der Schaltung außerhalb des Abfragepfades ist ein logisches Netzwerk, was eine sehr rationelle Ausgestaltung des Testgenerators  und der Fehlersimulationsprogramme erlaubt. Bei einem unvollständigen Abfragepfad wird angenommen, daß eine vorgegebene Anzahl von Flipflops nicht in den Abfragepfad einbezogen sind. Flipflops, die sehr leicht ansteuerbar oder beobachtbar sind, werden dem Abfragepfad oft entzogen, so daß nur diejenigen Flipflops in ihm verbleiben, die sonst nicht geprüft werden können.

Der Teil der Schaltung, der übrigbleibt, nachdem die zum Abfragepfad gehörenden Flipflops entfernt worden sind, wird im folgenden als der restliche Teil der Schaltung bezeichnet.

Wenn die Flipflops außerhalb des unvollständigen Abfragepfades asynchron sind, können vier typische Konfigurationen der Flipflops in Bezug auf den unvollständigen Abfragepfad unterschieden werden. Diese vier Fälle sind jeweils in den Figuren 1A bis 1D dargestellt. Asynchrone Flipflops werden allgemein verwendet, und zwar in vielen Schaltungen. In den Fällen A oder B können die asymmetrischen Flipflops nur über die primären Eingänge angesteuert werden. Diese beiden Konfigurationen werden als "optimal" bezeichnet (optimaler unvollständiger Abfragepfad), weil sie als Schaltungen mit vollständigem Abfragepfad behandelt werden können. Die Fehlersuche findet entweder an den primären Ausgängen (Fall A) oder an den Flipflops des Abfragepfades (Fall B) statt, deren Inhalte hinausgeschoben werden müssen. Da es möglich ist, daß die asynchronen Flipflops öfter angesteuert und überprüft werden müssen, als der Abfragepfad geladen und entladen werden muß, ist die Konfiguration nach Fall A vorteilhafter als die nach Fall B. Das bedeutet, daß man mit einem automatischen Tester die Prüfung im Fall A schneller durchführen kann als im Fall B, wenn man Schaltungen gleicher Komplexität und Größe voraussetzt.

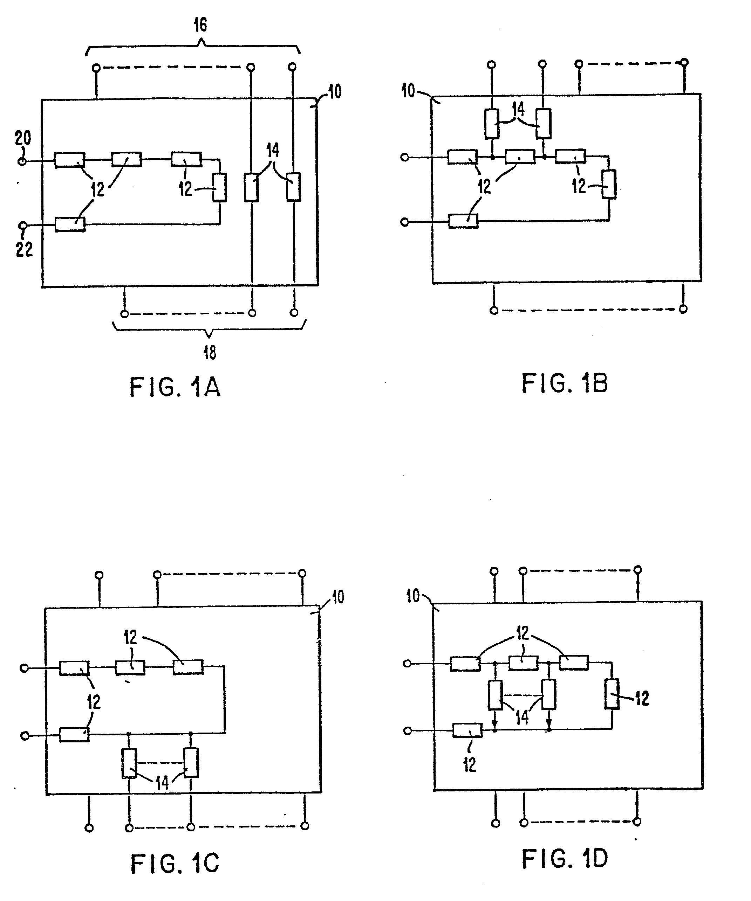

Wenn die außerhalb des Abfragepfades liegenden asynchronen Flipflops durch die Flipflops des Abfragepfades angesteuert werden (Figuren 1C und 1D), müssen die gesamte Schaltung und sämtliche Verschiebeoperationen für das Eingeben und Auslesen der Muster in den bzw. aus dem Abfragepfad simuliert werden, weil die Schaltzustände der asynchronen Flipflops durch das Weiterschieben eines Testmusters über die Flipflops des Abfragepfades beeinflußt werden können. Eine solche Konfiguration wird daher als "nicht-optimal" bezeichnet (nicht-optimal implementierter unvollständiger Abfragepfad).

Ein Problem einer Schaltung mit einem nicht-optimalen unvollständigen Abfragepfad liegt darin, daß die Schaltzustände der asynchronen Flipflops durch die Beaufschlagung der Abfrage-Flipflops mit einem Testmuster so beeinflußt werden, daß es nicht möglich ist, die Schaltzustände der asynchronen Flipflops mit vollständiger Sicherheit zu bestimmen, es sei denn, daß die gesamte Schaltung und die angewendeten Testmuster simuliert werden. Das gilt insbesondere für den restlichen Teil von Schaltungen mit einer sequentiellen Folge (sequential depth) von mehr als 1. Dadurch wird es notwendig, beim Nachbilden (modeling) und bei der Testgeneration in unterschiedlicher Weise vorzugehen. Obwohl eine automatische Testgeneration (ATG) auch hier auf den restlichen Teil der Schaltung beschränkt werden kann, müssen die resultierenden Muster auf der Ebene der gesamten Schaltung durch Fehlersimulation verifiziert werden.

Ein charakteristisches Merkmal eines nicht-optimalen unvollständigen Abfragepfades besteht darin, daß das Einspeisen der Testmuster simuliert werden muß. Das Einspeisen eines Testmusters in einen unvollständigen Abfragepfad kann aufgefaßt werden als die Einspeisung von Testmustern, die Pseudozufalls-Testmustern ähnlich sind, an den Eingängen der restlichen Schaltung. Mit anderen Worten: diese Muster führen nur rein zufällig zum Erkennen von Fehlern in der restlichen Schaltung.

Die der Erfindung zugrundeliegende Aufgabe besteht darin, ein Verfahren zum Prüfen einer komplexen digitalen Schaltung anzugeben, welche als eine prüfbare Abfrage-Struktur entworfen worden ist. Insbesondere soll die digitale Schaltung eine Anzahl von primären Eingängen, eine Anzahl von primären Ausgängen und eine Mehrzahl von Flipflops aufweisen, wobei von diesen Flipflops einige wahlweise zu einem Schieberegister verbindbar sind, das einen Abfragepfad bildet. Dabei kann es sich um einen nicht-optimalen unvollständigen Abfragepfad handeln, bei dem die oben angedeuteten Probleme kaum in Erscheinung treten oder ganz vermieden sind.

Diese Aufgabe wird erfindungsgemäß bei einem eingangs erwähnten Verfahren dadurch gelöst, daß nach dem Rücksetzen der Flipflops des Abfragepfad-Schieberegisters ein digitales Testmuster an die primären Eingängen gelegt wird, daß das erste Bit eines weiteren digitalen Testmusters in das Abfragepfad-Schieberegister über dessen Eingang eingeschoben wird, daß die an den primären Ausgängen auftretenden Bits mit denen einer ersten digitalen Zahl verglichen werden, die eine einwandfreie Funktionsweise der Schaltung angibt, daß das nächstfolgende Bit des weiteren digitalen Testmusters in das Abfragepfad-Schieberegister über dessen Eingang eingeschoben wird, daß die an den primären Ausgängen auftretenden Bits mit denen einer anderen digitalen Zahl verglichen werden, die eine einwandfreie Funktionsweise der Schaltung angibt, daß die beiden letztgenannten Schritte für nachfolgende Bits des weiteren digitalen Testmusters durchgeführt werden, und zwar insbesondere so lange, bis alle Stufen des Abfragepfad-Schieberegisters mit Bits des weiteren digitalen Testmusters belegt sind, und daß ein eine Fehlfunktion der Schaltung anzeigendes Signal erzeugt wird, wenn die an den primären Ausgängen auftretenden Bits nicht mit denen der mit ihnen verglichenen digitalen Zahlen übereinstimmen.

Bevorzugte Ausgestaltungen des Verfahren nach der Erfindung sind in den Ansprüchen 2 bis 4 angegeben. Der Anspruch 5 ist auf eine bevorzugte Anordnung zur Durchführung des Verfahrens nach der Erfindung gerichtet.

Die Erfindung wird nachfolgend anhand einiger bevorzugter Ausführungsbeispiele und anhand der Zeichnung näher erläutert. Dabei zeigen:

Figuren 1A und 1B Schaltbilder von digitalen Schaltungen, die einen unvollständigen Abfragepfad und optimale Flipflop-Konfigurationen außerhalb des Abfragepfades aufweisen,

Figuren 1C und 1D Schaltbilder von digitalen Schaltungen, die einen unvollständigen Abfragepfad und nichtoptimale Flipflop-Konfigurationen außerhalb des Abfragepfades aufweisen,

Figur 2 das Blockschaltbild eines Gerätes zum Prüfen einer digitalen Schaltung nach dem erfindungsgemäßen Verfahren,

Figur 3 das Schaltbild einer digitalen Schaltung mit einem nicht-optimalen unvollständigen Abfragepfad, die zur Fehlersuche im restlichen Teil der Schaltung mittels Pseudozufalls-Testmustern eingerichtet ist,

Figuren 4A und 4B Schaltbilder von digitalen Schaltungen
mit unvollständigen Abfragepfaden, die eine günstige (Figur 4A) und eine ungünstige Konfiguration (Figur 4B) für eine Verbesserung der Fehlererkennung aufweisen,

Figuren 5A und 5B Schaltbilder von digitalen Schaltungen mit einem Abfragepfad, bei denen ein sensitivierter Pfad durch die Anwendung eines Taktimpulses (Fig. 5A) und seine Erweiterung durch die Anwendung dreier Taktimpulse (Fig. 5B) dargestellt sind,

Figur 6 ein erstes Diagramm, das die Fehlererkennungsrate bei einer digitalen Schaltung in Abhängigkeit von der Anzahl der Taktperioden im normalen Betriebsmodus angibt, und

Figur 7 ein zweites Diagramm, das den relativen Anstieg der Fehlererkennungsrate in einer digitalen Schaltung in Abhängigkeit von der Anzahl der Taktperioden im normalen Betriebsmodus darstellt, so daß die optimale Anzahl von Taktperioden ermittelt werden kann.

Im folgenden sind gleiche Elemente in den verschiedenen Figuren jeweils mit denselben Bezugszeichen versehen.

Die Figuren 1A bis 1D zeigen jeweils eine komplexe digitale Schaltung 10, die eine Anzahl Flipflops 12 und 14 enthält. Wenn die Schaltung 10 im normalen Modus betrieben wird, sind die Flipflops 12, 14 so angeschlossen, daß sie verschiedene normale Schaltungsfunktionen erfüllen. Zu diesem Zweck hat die Schaltung 10 auch eine Anzahl von primären Eingängen 16 und eine Anzahl von primären Ausgängen 18. Befindet man sich im Testmodus, so sind die Flipflops 12 (die alle oder nicht alle Flipflops der Schaltung 10 umfassen) in Serie zueinander geschaltet, so daß ein Schieberegister oder ein sog.

Abfragepfad entsteht. Der Eingang dieses Schieberegisters ist mit 20 bezeichnet, sein Ausgang mit 22. Danach wird eine erste Testmusterzahl, die die Signale "1" und "0" enthält, über den Eingang 20 in das Register eingeschoben. Nachdem das Testmuster vollständig eingeschoben worden ist, wird die Schaltung eine Taktperiode lang normal betrieben, wobei ein zweites Testmuster den Primäreingängen 16 zugeführt wird. Durch diesen Vorgang werden die Flipflops in einer bestimmten, vorgegebenen Weise betätigt.

Nach dem Zuführen des zweiten Testmusters über die primären Eingänge und der Operation der Schaltung für die Dauer einer Taktperiode werden die Zustände der primären Ausgänge zwischengespeichert und mit ihren Sollwerten verglichen. Danach wird die digitale Zahl, die im Abfragepfad-Schieberegister gespeichert ist, über den Ausgang 22 ausgegeben und mit ihrem Sollwert (d.h. mit der Zahl, die im Schieberegister nach Beendigung des Tests bei einwandfrei funktionierender Schaltung gespeichert wäre) verglichen.

Wie bereits oben beschrieben, können die Flipflops 14 außerhalb des Abfragepfades durch Signale von den primären Eingängen 16 eingestellt werden. Diese zwei Konfigurationen werden nun als "optimal" bezeichnet, weil die Flipflops 14 direkt geprüft werden können, indem Signale ihren Eingängen zugeführt werden und ihre Ausgangssignale überprüft werden, und zwar entweder direkt wie bei der Schaltung nach Figur 1A oder indirekt über das Abfragepfad-Schieberegister wie in der Schaltung nach Figur 1B.

In den Schaltungen der Figuren 1C und 1D werden die außerhalb des Abfragepfades liegenden Flipflops 14 durch die Flipflops 12 des Abfragepfades angesteuert. In

diesem Fall müssen die ganze Schaltung und sämtliche Schiebeoperationen für das Einspeisen und Auslesen des Musters in den bzw. aus dem Abfragepfad simuliert werden, weil die Schaltzustände der Flipflops 14 durch das Einlesen der Testmuster in das Ablese-Schieberegister beeinflußt werden können. Aus diesem Grunde werden die Flipflopschaltungskonfigurationen der Figuren 1C und 1D als "nicht-optimal" bezeichnet.

Die oben beschriebene, sog. Abfragepfad-Technik zum Prüfen einer digitalen Schaltung ist bereits seit einiger Zeit bekannt. Diese Technik wird beispielsweise in dem obengenannten US-Patent 3 761 695, in der DT-AS 2 111 493 und in dem Aufsatz "Build-In Test for Complex Digital Integrated Circuits" von Koenemann und anderen, IEEE Journ. of Solid State Circuits, Bd. SC-15, No. 3, Juni 1980, Seiten 315-319, beschrieben. Obwohl diese Prüftechnik üblicherweise für Schaltungen mit einem vollständigen Abfragepfad und auch für Schaltungen mit einem optimalen unvollständigen Abfragepfad ausreicht, ist sie für komplexe digitale Schaltungen, die einen nicht optimalen unvollständigen Abfragepfad haben, nicht mehr ausreichend. Wie oben erwähnt wurde, entstehen beim Einspeisen eines Testmusters in eine Schaltung mit einem nicht-optimalen, unvollständigen Abfragepfad an den Eingängen der restlichen Schaltung Muster, die als Pseudozufalls-Testmuster aufgefaßt werden können. Daher können Fehler in der restlichen Schaltung nur durch einen Zufall entdeckt werden.

Mit dem Prüfverfahren nach der Erfindung ist es möglich, die Fehlererkennungsrate (d.h. den Prozentsatz der erkannten Fehler) in dem restlichen Teil einer Schaltung, die einen nicht optimalen, unvollständigen Abfragepfad enthält, wesentlich zu erhöhen.

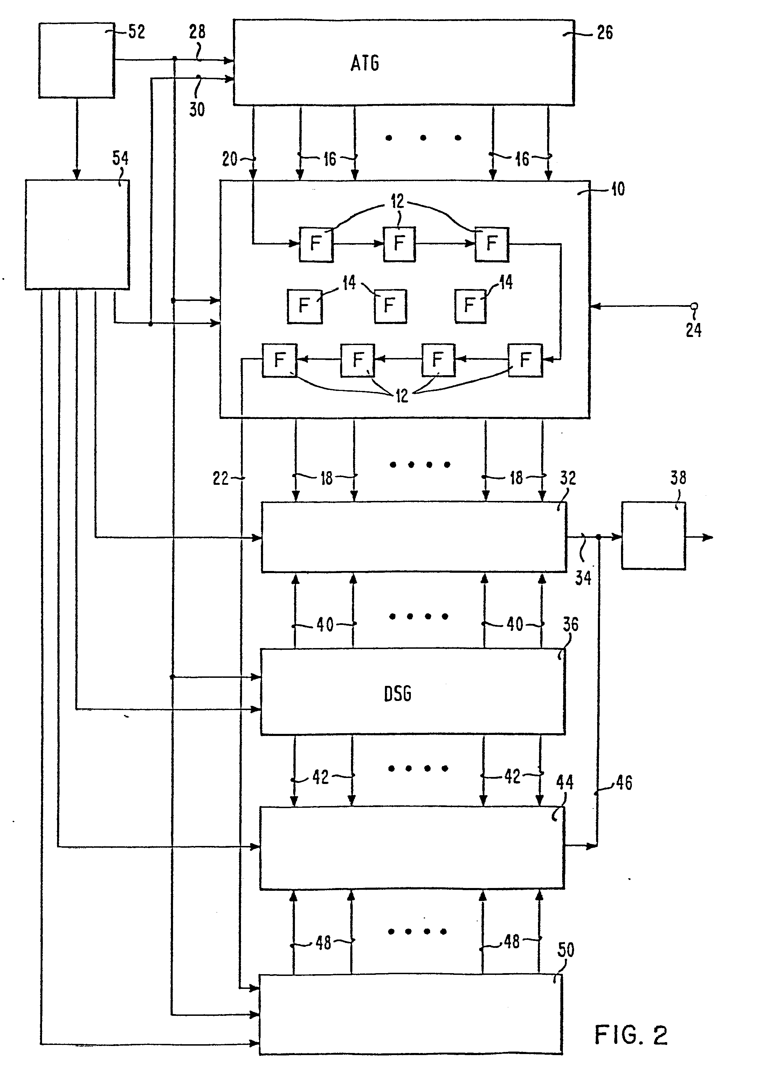

Fig. 2 zeigt eine Anordnung zur Durchführung des Verfahrens nach der Erfindung zum Prüfen einer komplexen digitalen Schaltung 10 mit einem nicht-optimalen, unvollständigen Abfragepfad. Wie in den Figuren 1A bis 1D, enthält die Schaltung 10 Flipflops 12, die miteinander verbunden werden können, so daß sie ein Abfragepfad-Schieberegister bilden, und Flipflops 14, die außerhalb dieses Schieberegisters liegen, wenn die Schaltung 10 im Testmodus arbeitet.

Die Schaltung 10 hat einen eigenen Eingang 24, über den entweder ihr normaler Modus, in dem alle Flipflops normal angeschlossen sind, um die Schaltungsfunktionen zu erfüllen, oder der Testmodus, in dem die Flipflops 12 zueinander in Serie geschaltet werden, so daß sich der Abfragepfad ergibt, ausgewählt werden kann. In Fig. 2 wird die Schaltung 10 in ihrer Testmodus-Konfiguration gezeigt, in dem die primären Eingänge 16, die primären Ausgänge 18 und der Eingang 20 sowie der Ausgang 22 des Abfragepfades mit der Prüfanordnung verbunden sind.

Die Prüfanordnung umfaßt einen automatischen Prüfmustergenerator 26, der zur Zuführung eines digitalen Testmusters an die primären Eingänge 16 und an den Eingang 20 des Abfragepfades in Abhängigkeit von Taktsignalen an seinen Takteingängen 28 und 30 dient. Die primären Ausgänge 18 der Schaltung 10 sind mit einem Komparator 32 verbunden, der an seinem Ausgang 34 ein Signal abgibt, wenn die Zustände an den primären Ausgängen 18 nicht mit den Signalen "1" und "0" einer bekannten digitalen Zahl übereinstimmen, die durch einen digitalen Signalgenerator 36 erzeugt wird. Diese digitale Zahl gibt die Sollzustände an den primären Ausgängen 18 an, wenn die Schaltung 10 einwandfrei arbeitet. Das Ausgangssignal des Komparators wird in einem Flipflop 38 zwischengespeichert, das anzeigt, ob die Schaltung 10 fehlerhaft ist
oder nicht.

Die dem Komparator 32 vom digitalen Signalgenerator 36
gelieferte digitale Zahl wird über Ausgänge 40 zugeführt. Der digitale Signalgenerator 36 gibt eine andere
digitale Zahl über weitere Ausgänge 42 an einen zweiten
Komparator 44 ab. Dieser liefert an seinem Ausgang 46
ein Signal, wenn die Zahl, die er vom digitalen Signalgenerator 36 erhalten hat, nicht einer Zahl entspricht,
die er über die Ausgänge 48 eines Schieberegisters 50
zugeführt erhält. Die Schaltung 10, der automatische
Testmustergenerator 26, der digitale Signalgenerator 36,
die Komparatoren 32 und 44 und das Schieberegister 50
erhalten Taktsignale, die von einem Taktimpulsgenerator
52 über eine Zeitschaltung (Spannungsteiler) 54 abgeleitet werden.

Die Anordnung nach Fig. 2 arbeitet in folgender Weise:
Zunächst werden die sieben Flipflops 12 im Abfragepfad-
Schieberegister auf "0" rückgesetzt. Anschließend wird
ein erstes digitales Testmuster im automatischen Testmustergenerator (ATG) 26 erzeugt und den primären Eingängen 16 der Schaltung 10 zugeführt. Dieses Testmuster
wird während des gesamten Tests der Schaltung 10 nicht
verändert. In einem nächsten Schritt schiebt der ATG 26
das erste Bit eines zweiten digitalen Testmusters über
den Eingang 20 des Abtastpfades in das Abtastpfad-Schieberegister ein. Da in dem dargestellten Ausführungsbeispiel sieben Flipflops in dem Abtastpfad-Schieberegister
vorhanden sind, besteht das zweite digitale Testmuster
aus sieben Bits.

In einem nächsten Schritt werden die Bits, die an den
primären Ausgängen 18 der Schaltung 10 erscheinen, im

**0144078**

Komparator 32 mit den entsprechenden Bits der ersten digitalen Zahl verglichen, die mittels des digitalen Signalgenerators (DSG) 36 erzeugt wird. Diese digitale Zahl ist kennzeichnend für eine einwandfreie Arbeitsweise der Schaltung, d.h. sie gibt die Zustände an den Primärausgängen 18 an, die auftreten würden, wenn die Schaltung 10 einwandfrei arbeiten würde.

Anschließend wird das nächste Bit des zweiten digitalen Testmusters durch den ATG 26 über den Eingang 20 des Abtastpfades in das Abfragepfad-Schieberegister eingeschoben. Danach werden die Zustände der primären Ausgänge wieder mit den Bits einer zweiten digitalen Zahl verglichen, die von dem DSG 36 erzeugt wird und eine ordnungsgemäße Arbeitsweise der Schaltung 10 kennzeichnet.

Das Einschieben der Bits des zweiten digitalen Testmusters in das Abfragepfad-Schieberegister und der sich anschließende Vergleich der Zustände der primären Ausgänge 18 mit den Bits einer Zahl, die vom DSG 36 erzeugt wird, wird wiederholt. Immer wenn der Komparator 32 ungleiche Eingangssignale anzeigt, wird ein an seinem Ausgang 34 auftretendes Signal im Flipflop 38 zwischengespeichert.

Wie weiter unten noch gezeigt werden wird, erhöhen die Schritte des Verschiebens und des nachträglichen Vergleichs die Fehlererkennungsrate für den restlichen Teil der Schaltung, d.h. für die Flipflops 14 und die mit ihnen verbundenen Gatterschaltungen, die nicht dem Abfragepfad-Schieberegister angehören.

Nachdem die benötigte Anzahl von Bits des zweiten Testmusters in das Abfragepfad-Schieberegister eingeschoben worden sind und die Zustände der primären Ausgänge überprüft worden sind, werden die restlichen Bits des zweiten Testmusters eingeschoben, bis sämtliche Stufen des Abfragepfad-Schieberegisters beaufschlagt worden sind. Danach wird die Schaltung für die Dauer von einer oder mehreren Taktperioden betrieben, wonach die Zustände der primären Ausgänge neuerlich auf das Vorliegen von korrekten Signalen überprüft werden.

Nach dem Abschluß des vorstehend beschriebenen Testverfahrens werden die Inhalte des Abfragepfad-Schieberegisters über den Ausgang 22 in das zweite Schieberegister 50 übertragen. Wenn sämliche sieben Bits des Abfragepfad-Schieberegisters in das Schieberegister 50 übernommen worden sind, werden die im Schieberegister 50 gespeicherten Bits im Komparator 44 mit einer anderen digitalen Zahl verglichen, die an den Ausgängen 42 des DSG 36 erscheint und für eine einwandfreie Operation der Schaltung 10 kennzeichnend ist. Wenn die Digits, die jeweils vom Schieberegister 50 und von dem DSG 36 erhalten werden, nicht gleich sind, gibt der Komparator 44 ein Signal über seinen Ausgang 46, das im Flipflop 38 zwischengespeichert wird.

Das im Rahmen der vorliegenden Erfindung vorgenommene Verschieben und Prüfen von Bits wird in der folgenden Tabelle 1 veranschaulicht. Diese Tabelle zeigt, wie ein aus sieben Bits bestehendes Testmuster - in diesem Falle "0110101" - von dem ATG 26 durch das Abfragepfad-Schieberegister in der Schaltung 10 in das Schieberegister 50 eingeschoben wird.

Tabelle 1

| Schritt | Testmuster | Schaltung | Primäre Ausgänge |
|---|---|---|---|
| 0 | | .1101100 | |
| 1 | 0110101 | .0000000 | .0000000 |
| 2 | 011010 | .1000000 | .0000000 |
| 3 | 01101 | .0100000 | .0000000 |
| 4 | 0110 | .1010000 | .0000000 |
| 5 | 011 | .0101000 | .0000000 |
| 6 | 01 | .1010100 | .0000000 |
| 7 | 0 | .1101010 | .0000000 |
| 8 | | .0110101 | .0000000 |
| 9 | | .011010 | .1000000 |
| 10 | | .01101 | .0100000 |
| 11 | | .0110 | .1010000 |
| 12 | | .011 | .0101000 |
| 13 | | .01 | .1010100 |
| 14 | | .0 | .1101010 |
| 15 | | . | .0110101 |

Die Flipflops 12 der Schaltung 10 befinden sich zunächst in beliebigen Schaltstellungen (Schritt 0). Die aufeinanderfolgenden Schaltstellungen "1101100" sind als ein Beispiel hierfür angegeben. Die Schaltung 10 wird dann in den Testmodus geschaltet, wodurch die Flipflops 12 in Serie zueinander zu einem Schieberegister zusammengeschaltet und auf "0" rückgesetzt werden (Schritt 1). Danach werden das Testmuster "0110101" in das Abfrage-Schieberegister Bit für Bit eingeschoben (Schritte 2 bis 8) und die Schaltzustände der primären Ausgänge nach jeder Schiebeoperation bezüglich des Vorliegens der richtigen Werte überprüft. In Abhängigkeit von der Anordnung der Flipflops innerhalb der Schaltung 10 (wie nahe sie den primären Ausgängen 18 sind) kann dieses Prüfverfahren die Fehlererkennungsrate bezüglich der Flipflops 14 und der ihnen zugeordneten Gatter wesentlich erhöhen.

**0144078**

In Anschluß hieran wird so vorgegangen, daß, nachdem die Schaltung 10 getaktet worden ist und die primären Ausgänge wieder bezüglich des Vorliegens der richtigen Werte überprüft worden sind, die Inhalte des Abfragepfad-Schieberegisters Bit für Bit herausgeschoben und in das Schieberegister 50 eingeschoben werden (Schritte 9 bis 15). Schließlich werden die Inhalte dieses Schieberegisters auf das Vorliegen der richtigen Werte überprüft.

Es ist zu beachten, daß sich die Schaltzustände des Abfragepfad-Schieberegisters, das aus den Flipflops 12 besteht, während des Prüfvorgangs ändern können. Zum besseren Verständnis wird zwar gezeigt, daß das Testmuster "0110101" unverändert über die Abfragepfad-Schieberegister in das Schieberegister 50 gelangt. Es ist aber verständlich, daß sich die Elemente des Schieberegisters 50 nach Beendigung des Prüfverfahrens normalerweise von dem ursprünglichen Testmuster, das dem Abfragepfad-Schieberegister zugeführt worden war, unterscheiden.

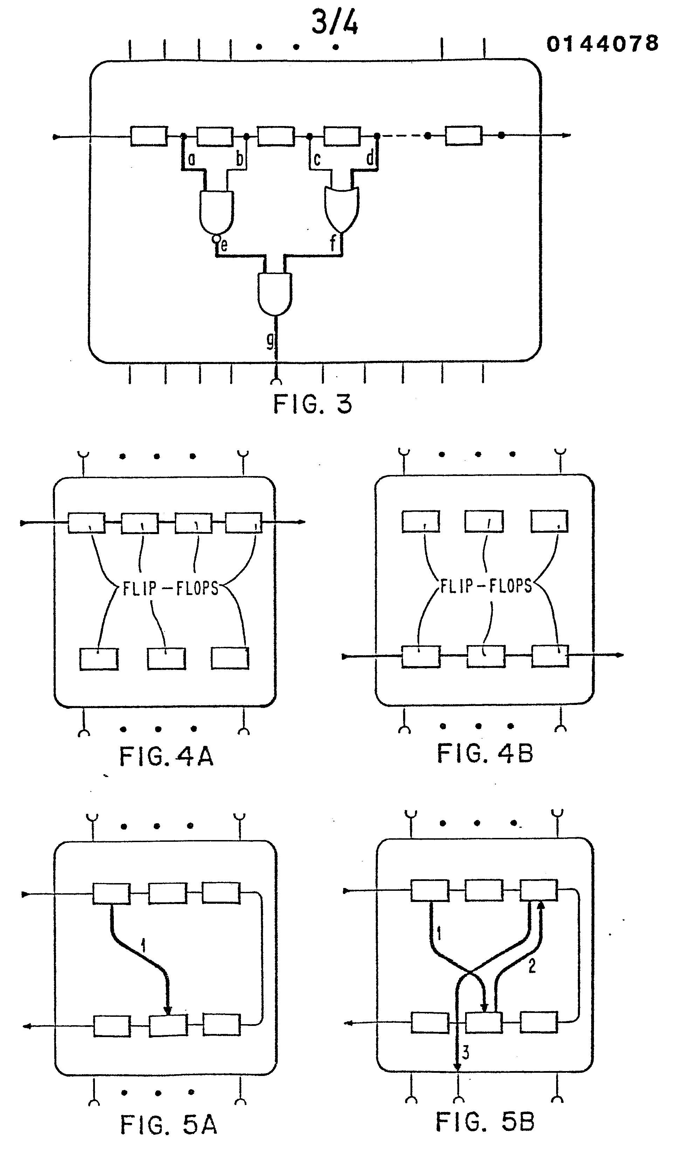

Wie oben festgestellt wurde, erhöht das Prüfverfahren nach der Erfindung die Fehlererkennungsrate im Vergleich zu den bisher bekannten Methoden (die oben in Verbindung mit Fig. 1A beschrieben wurden) beträchtlich. Diese Verbesserung wird nun anhand der Fig. 3 näher erläutert.

Im Testmodus erzeugt der Testgenerator 26 ein Testmuster und speist es in den unvollständigen Abfragepfad ein, der zu Beginn lauter "0"-Signale enthält. Nach dem Einspeisen werden mit Hilfe dieses Testmusters alle "stuck-at"-Fehler entlang der stark ausgezogenen Linien der Fig. 3 erkannt. Liegt ein "stuck-at"-Fehler vor, so wird ein Schaltungspunkt unabhängig von den ihm zugeführten Signalen stets auf einem bestimmten Signal festgehalten.

Acht Taktperioden sind notwendig, um das Testmuster
vollständig in die gewünschte Position im Abfragepfad zu
schieben. Acht Zwischenmuster erscheinen während des
Schiebens, aber nur das letzte, erwünschte Muster wird
in Schaltungen mit einem vollständigen Abfragepfad simuliert. Bei Schaltungen mit einem nicht-optimalen, unvollständigen Abfragepfad werden acht Muster simuliert. Die
folgende Tabelle 2 zeigt alle zwischenzeitlich auftretenden Zustände und die zugehörigen Fehlererkennungsraten.

## Tabelle 2

| Anzahl der Takte | Schritte 1 2 3 4 5 6 7 8 | Fehler-erkennung | Fehlererkennungsrate | Bemerkung |
|---|---|---|---|---|
| 0 | 0 0 0 0 0 0 0 0 | c' d' f' g' | | Zustand vor dem Einspeisen |
| 1 | 0 | c' d' f' g' | | |
| 2 | 1 0 | c' d' f' g' | | |
| 3 | 1 1 0 | g' | 92.85% | Zwischenzustände |
| 4 | 0 1 1 0 | a' c° e° f° g° | | an den Ausgängen der |
| 5 | 1 0 1 1 0 | b' e° f° g° | | Flipflops |
| 6 | 1 1 0 1 1 0 | a° b° e' g' | | |
| 7 | 1 1 1 0 1 1 0 | a° b° e' g' | | |
| 8 | 0 1 1 1 0 1 1 0 | a' e° f° g° | 28.57% | Fehlererkennung nach dem Einspeisen |

Die Tabelle 2 zeigt die Erzeugung von "Pseudozufalls"-
Testmustern während des Einspeisens in den Abfragepfad
der Schaltung nach Fig. 3, wobei a' ein Festhalten eines
Schaltungspunktes auf "I" und a ein Festhalten eines
Schaltungspunktes auf "O" bedeuten. Wie aus der Tabelle 2
ersichtlich ist, werden 92,85 % der Fehler während des
Einspeisens der ersten sieben Muster entdeckt. Das weitere (achte) Muster erhöht die Fehlererkennungsrate
nicht mehr.

Wenn die Schaltung nach Fig. 3 einen kompletten Abfragepfad hat, wird nur dieses weitere (achte) Muster simuliert, wobei die Fehlererkennungsrate nur 28,57 %
beträgt.

Wie hieraus ersichtlich ist, kann der Anstieg der
Fehlererkennunsrate bei einer Fehlersimulation mittels
aller Muster während des Einspeisens in einen unvollständigen Abfragepfad nach dem erfindungsgemäßen Verfahren ganz beträchtlich sein.

Experimente mit einem hochintegrierten LSI-Chip (mit 651
Gattern, 39 Flipflops im Abfragepfad und vier Flipflops
außerhalb desselben), der einen nicht-optimalen, unvollständigen Abfragepfad hatte, zeigten ebenfalls einen
wesentlichen Anstieg der Fehlererkennungsrate:

Fehlererkennungsrate nach dem Einspeisen
des letzten Musters                            = 18,36 %

Fehlererkennungsrate während des Einspeisens (einschließlich des letzten Musters) = 83,42 %.

Von der Struktur der Schaltung hängt es ab, ob ein
solcher Anstieg der Fehlererkennungsrate auftreten kann
oder nicht und wenn ja, wie groß er ist. Nur der Teil
der Schaltung, der zwischen den Abfragepfad-Flipflops
und den primären Ausgängen liegt, kann überprüft werden.
Wenn dieser Teil groß ist (vgl. Fig. 4A), dann ist der
Anstieg der Fehlererkennungsrate groß. Wenn ein Teil der
Schaltung zwischen den primären Eingängen und den Abfra-
gepfad-Flipflops liegt (Fig. 4B), ergibt sich eine niedrige Fehlererkennungsrate oder eine Fehlererkennung ist
gar nicht möglich. Hierin könnte ein weiteres Kriterium
für das Anwenden und die Anordnung eines unvollständigen
Abfragepfades in einer Schaltung liegen.

Nachdem ein Testmuster in einen unvollständigen Abfragepfad eingespeist worden ist, wird die Schaltung in den
normalen Betriebsmodus geschaltet und der Systemtakt
während einer Taktperiode angelegt, um einen Datentransfer zu den Flipflops zu ermöglichen. Die Zustände der
primären Ausgänge werden überprüft und das Muster, das
die Zustände des unvollständigen Abfragepfades angibt,
wird herausgeschoben.

Experimente haben gezeigt, daß die Anwendung des Systemtaktes für mehr als eine Taktperiode die Fehlererkennungsrate wesentlich erhöht.

Sensitivierte Pfade beginnen im allgemeinen entweder an
primären Eingängen oder an Ausgängen von Flipflops und
enden entweder an primären Ausgängen oder an Eingängen
von Flipflops. Vielfaches Takten im normalen Betriebsmodus kann die sensitivierten Pfade über mehrere Flipflops hinweg ausdehnen und dadurch die Fehlererkennungsrate vergrößern. Das wird anhand von Fig. 5A (Anwendung
einer Taktperiode) und Fig. 5B (Anwendung von drei
Taktperioden) verdeutlicht. Wegen der Abhängigkeit von
den strukturellen Gegebenheiten der Schaltung und von
dem verwendeten Testmuster gibt es keine Garantie, daß
die sensitivierten Pfade ausgedehnt werden können.

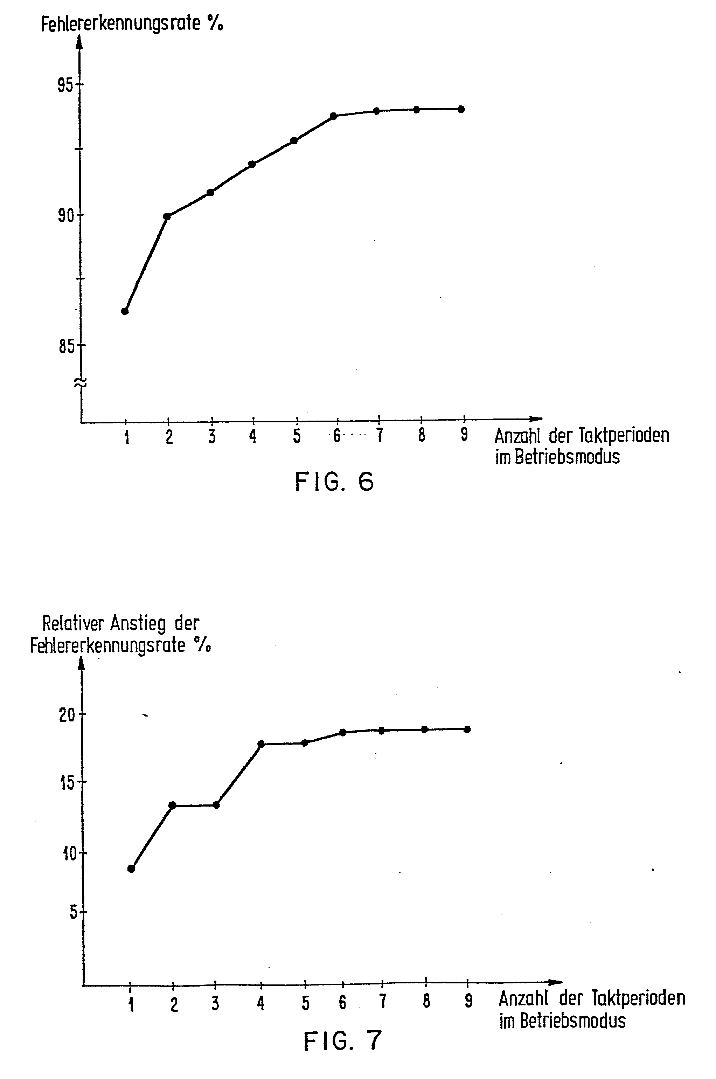

Experimentelle Ergebnisse bei einem LSI-Chip haben einen
beachtlichen Anstieg der Fehlererkennungsrate in Abhängigkeit von dem Takten im normalen Betriebsmodus gezeigt. Zur Verdeutlichung dieser Ergebnisse dient die
Fig. 6. In dem LSI-Schaltungstest, der dem Diagramm von
Fig. 6 zugrundeliegt, wurden Testmuster, die mittels
eines ATG-Programms erzeugt wurden, sechsmal in den Abfragepfad eingespeist. Nachdem aus dem Testmodus in den
normalen Betriebsmodus umgeschaltet worden war, wurde

**0144078**

eine variierende Zahl von Taktimpulsen zugeführt (von 1 bis 9). Wie aus dem Diagramm hervorgeht, erhöhte sich die Fehlererkennungsrate von 86,27 % (eine Taktperiode) auf 94,04 % (9 Taktperioden).

Bei der praktischen Anwendung des Verfahrens nach der Erfindung sollten zwei Gesichtspunkte untersucht werden:

(1) Kann eine Erhöhung der Fehlererkennungsrate erreicht werden?

(2) Wenn ja, wieviele Taktperioden ergeben das beste Resultat?

Das kann gemacht werden, indem man die Anzahl der Taktperioden nach dem ersten Einspeisen in den unvollständigen Abfragepfad variiert, wie in Fig. 7 dargestellt ist. Nach einem Diagramm entsprechend der Fig. 7 kann die Anzahl der Taktperioden ermittelt werden, die die besten Resultate ergibt.

Bei umfangreichen Schaltungen kann es zweckmäßig sein, ein Optimum zwischen dem Anstieg der Fehlererkennungsrate und dem Anstieg der Simulationskosten zu finden. Für den LSI-Chip, der in dem oben erwähnten Experiment verwendet wurde, bestand kein wesentlicher Unterschied bezüglich der Simulationszeit oder der Gesamtkosten zwischen einer und neun Taktperioden.

5 Patentansprüche

7 Figuren

Patentansprüche

1. Verfahren zum Prüfen einer komplexen digitalen Schaltung, bei der jeweils mehrere primäre Eingänge, primäre Ausgänge und Flipflops vorgesehen sind, wobei wenigstens einige der letzteren wahlweise zu einem Abfragepfad-Schieberegister verbindbar sind, und bei der das Abfragepfad-Schieberegister mit einem Eingang und einem Ausgang versehen ist, d a d u r c h   g e k e n n z e i c h - n e t , daß nach dem Rücksetzen der Flipflops (12) des Abfragepfad-Schieberegisters ein digitales Testmuster an die primären Eingänge (16) gelegt wird, daß das erste Bit eines weiteren digitalen Testmusters in das Abfragepfad-Schieberegister über dessen Eingang (20) eingeschoben wird, daß die an den primären Ausgängen (18) auftretenden Bits mit denen einer ersten digitalen Zahl verglichen werden, die eine einwandfreie Funktionsweise der Schaltung (10) angibt, daß das nächstfolgende Bit des weiteren digitalen Testmusters in das Abfragepfad-Schieberegister über dessen Eingang (20) eingeschoben wird, daß die an den primären Ausgängen (18) auftretenden Bits mit denen einer anderen digitalen Zahl verglichen werden, die eine einwandfreie Funktionsweise der Schaltung (10) angibt, daß die beiden letztgenannten Schritte für nachfolgende Bits des weiteren digitalen Testmusters durchgeführt werden, und zwar insbesondere so lange, bis alle Stufen des Abfragepfad-Schieberegisters mit Bits des weiteren digitalen Testmusters belegt sind, und daß ein eine Fehlfunktion der Schaltung (10) anzeigendes Signal erzeugt wird, wenn die an den primären Ausgängen (18) auftretenden Bits nicht mit denen der mit ihnen verglichenen digitalen Zahlen übereinstimmen.

2. Verfahren nach Anspruch 1, d a d u r c h   g e - k e n n z e i c h n e t , daß die Schaltung (10) für mindestens eine Taktperiode in ihrem normalen Betriebsmodus betrieben wird, daß die an den primären Ausgängen
(18) auftretenden Bits mit denen einer weiteren digitalen
Zahl verglichen werden, die eine einwandfreie Funktionsweise der Schaltung (10) angibt, und daß ein eine Fehlfunktion der Schaltung anzeigendes Signal erzeugt wird,
wenn die an den primären Ausgängen (18) auftretenden Bits
nicht mit denen der mit ihnen verglichenen weiteren digitalen Zahl übereinstimmen.

3. Verfahren nach Anspruch 1 oder 2, d a d u r c h
g e k e n n z e i c h n e t , daß die Inhalte des Abfragepfad-Schieberegisters über den Ausgang (22) des Abfragepfades in ein zweites Schieberegister (50)
eingeschoben werden, daß die in dem zweiten Schieberegister (50) jeweils gespeicherten Bits mit den Bits
einer zusätzlichen digitalen Zahl verglichen werden, die
eine einwandfreie Funktionsweise der Schaltung (10) angibt, und daß ein eine Fehlfunktion der Schaltung (10)
anzeigendes Signal erzeugt wird, wenn die im zweiten
Schieberegister (50) gespeicherten Bits nicht mit denen
der zusätzlichen digitalen Zahl übereinstimmen.

4. Verfahren nach Anspruch 2, d a d u r c h   g e -
k e n n z e i c h n e t , daß die Anzahl der Taktperioden in der Weise bestimmt wird, daß die Schaltung für
eine Taktperiode betrieben und die Fehlererkennungsrate
festgestellt wird, daß dieser Schritt unter Zugrundelegung jeweils einer weiteren Taktperiode so lange wiederholt wird, bis die Fehlererkennungsrate nicht mehr wesentlich zunimmt, und daß die optimale Anzahl von Taktperioden unter Berücksichtigung der ansteigenden Fehlererkennungsrate einerseits und der ansteigenden Prüfkosten
andererseits ermittelt wird.

5. Anordnung zur Durchführung des Verfahrens nach einem der Ansprüche 1 bis 4, d a d u r c h   g e k e n n - z e i c h n e t ,   daß ein Prüfmustergenerator (26) mit den primären Eingängen der Schaltung (10) und dem Eingang (20) des Abfragepfades beschaltet ist, daß ein erster Komparator mit den primären Ausgängen (18) der Schaltung (10) und mit den ersten Ausgängen (40) eines digitalen Signalgenerators (36) beschaltet ist, daß ein zweiter Komparator (44) mit zweiten Ausgängen (42) des digitalen Signalgenerators (36) und mit den Ausgängen eines zweiten Schieberegisters (50) beschaltet ist, dessen Eingang mit dem Ausgang (22) des Abfragepfades verbunden ist, und daß über die Ausgänge des ersten und zweiten Komparators (32, 44) Signale abgegeben werden, die eine Fehlfunktion der Schaltung (10) anzeigen.

FIG. 1A

FIG. 1B

FIG. 1C

FIG. 1D

2/4

0144078

FIG. 2

3/4

0144078

FIG. 3

FIG. 4A

FIG. 4B

FIG. 5A

FIG. 5B

4/4

0144078

Fehlererkennungsrate %

FIG. 6

Anzahl der Taktperioden im Betriebsmodus

Relativer Anstieg der Fehlererkennungsrate %

FIG. 7

Anzahl der Taktperioden im Betriebsmodus